# EUROPÄISCHE PATENTSCHRIFT

(11) **EP 3 721 550 B1**
(45) Veröffentlichungstag und Bekanntmachung des Hinweises auf die Patenterteilung: **15.10.2025**
(21) Anmeldenummer: 18795425.0
(22) Anmeldetag: 23.10.2018
(51) Int. Cl.: H03K 17/687, H03F 1/02

(54) **FELDEFFEKTTRANSISTORANORDNUNG SOWIE VERFAHREN ZUM EINSTELLEN EINES DRAIN-STROMS EINES FELDEFFEKTTRANSISTORS**
FIELD-EFFECT TRANSISTOR ARRANGEMENT AND METHOD FOR SETTING A DRAIN CURRENT OF A FIELD-EFFECT TRANSISTOR
ENSEMBLE TRANSISTOR À EFFET DE CHAMP AINSI QUE PROCÉDÉ DE RÉGLAGE D'UN COURANT DE DRAIN D'UN TRANSISTOR À EFFET DE CHAMP

(30) Priorität: 08.12.2017 DE 102017222284
(43) Veröffentlichungstag der Anmeldung: 14.10.2020
(73) Patentinhaber: Robert Bosch GmbH, 70442 Stuttgart (DE)
(72) Erfinder: SCHNITZER, Reiner, 72762 Reutlingen (DE); SCHWARZENBERGER, Thomas, 70437 Stuttgart (DE); TRETTER, Gregor, 72760 Reutlingen (DE)
(86) Internationale Anmeldenummer: PCT/EP2018/079008
(87) Internationale Veröffentlichungsnummer: WO 2019/110192

(56) Entgegenhaltungen:
- US-A- 5 132 752
- US-A- 5 132 752
- US-A1- 2009 146 723
- US-A1- 2009 146 723
- US-A1- 2010 026 391
- US-A1- 2010 026 391

## Beschreibung

Die vorliegende Erfindung betrifft eine Feldeffekttransistoranordnung sowie ein Verfahren zum Einstellen eines Drain-Stroms eines Feldeffekttransistors.

### Stand der Technik

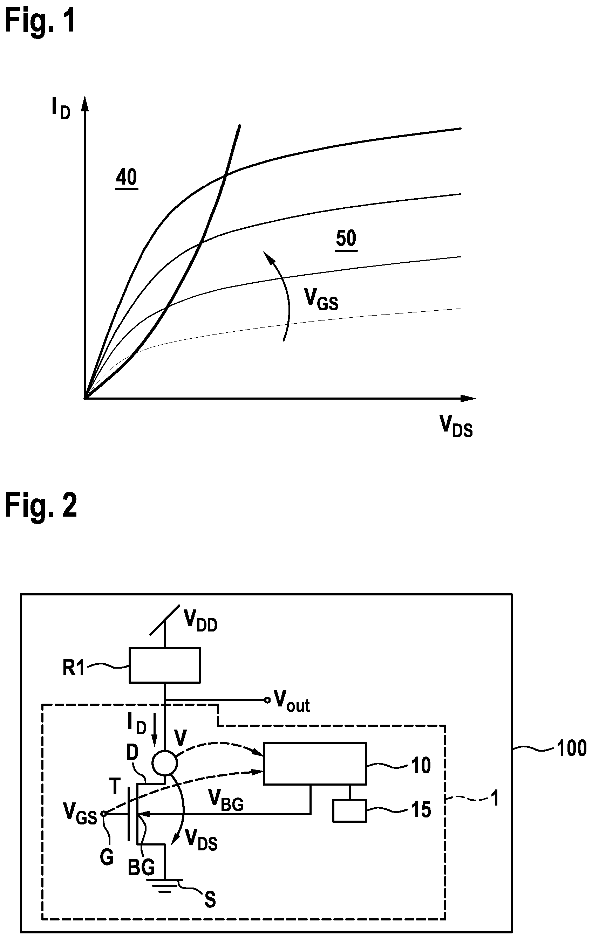

Durch parasitäre Effekte steigt der Drain-Strom I_{D} bei Feldeffekttransistoren im Sättigungsbereich, auch als Pinch-off-Bereich bezeichnet, mit zunehmender Drain-Source-Spannung V_{DS} an. Dieses unerwünschte Verhalten nimmt bei CMOS-Prozessen mit fortschreitender Transistor-Skalierung zu, wodurch die Ausgangskennlinienfelder von beispielsweise modernen CMOS-Feldeffekttransistoren einen beträchtlichen Anstieg aufweisen, siehe dazu auch die Figur 1 des Standes der Technik.

Der beschriebene Effekt führt nachteilig zu einer Reduktion des Kleinsignal-Drain-Source-Widerstands r_{DS} und somit auch zu einer Reduktion der intrinsischen Verstärkung Aᵢ des Feldeffekttransistors. Die intrinsische Verstärkung des Feldeffekttransistors beschreibt die maximale Spannungsverstärkung, die ein Feldeffekttransistor in einem bestimmten Arbeitspunkt erreichen kann. Diese berechnet sich für einen Feldeffekttransistor in Source-Schaltung mit hochohmiger Last aus dem Produkt der sogenannten Kleinsignal-Steilheit gₘ und dem Kleinsignal-Drain-Source-Widerstand r_{DS}. Hohe Werte dieser Größe sind wichtig für Anwendungen, welche große Verstärkung oder hohe Genauigkeit benötigen.

Durch komplexe Schaltungstopologien mit mehreren Feldeffekttransistoren können Verstärkerschaltungen mit hoher Spannungsverstärkung auch mit Feldeffekttransistoren mit geringer intrinsischer Verstärkung entworfen werden. Dies setzt jedoch die Stapelung mehrerer Feldeffekttransistoren voraus, was in skalierten CMOS-Technologien durch die geringe Versorgungsspannung schwierig bis unmöglich ist. Die Kombination aus beiden Effekten, der starken I_{D}(V_{DS})-Abhängigkeit und der geringen Versorgungsspannung sorgen dafür, dass eine hohe Spannungsverstärkung in skalierten CMOS-Prozessen nicht oder nur mit erheblichem Aufwand zu erreichen ist. In der US 2009/0146723 A1 und der US 5 132 752 A wird ein Verstärker-Schaltkreis mit einem Transistor bereitgestellt, deren Backgate-Spannung über einen Operationsverstärker angesteuert wird. In der US 2010/0026391 A1 wird eine Schaltungsanordnung offenbart, welche zwei in Serie geschaltete Transistoren aufweist und eine Steuereinheit aufweist, welche den Zwischenstrom zwischen den Transistoren über Backgates kontrolliert.

### Offenbarung der Erfindung

Erfindungsgemäß wird eine Feldeffekttransistoranordnung gemäß Anspruch 1 zur Verfügung gestellt.

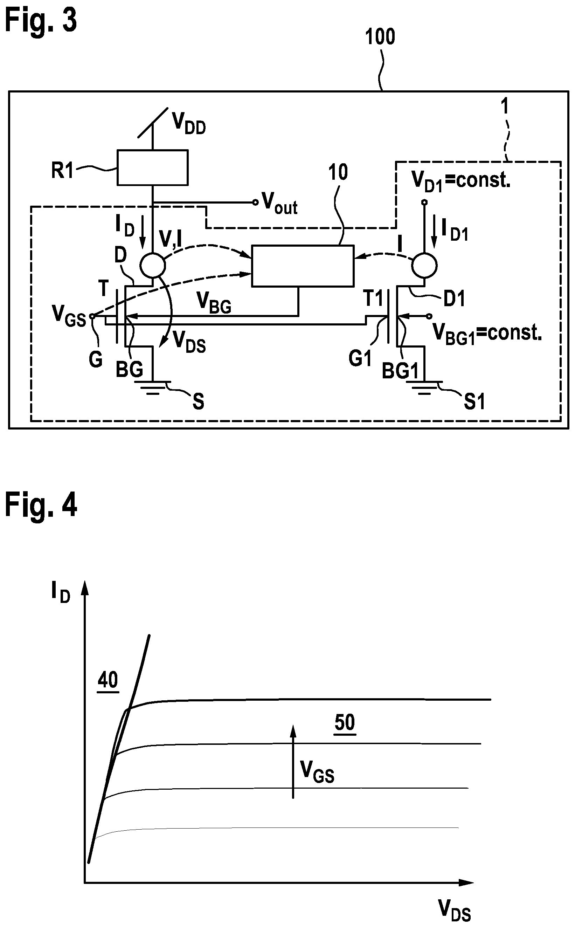

Die Erfindung hat den Vorteil, dass mittels der Regelung der Backgate-Spannung unerwünschte parasitäre Effekte kompensiert werden können. Dadurch können beispielsweise Ausgangskennlinien mit weitestgehend konstantem Drain-Strom in einem Sättigungsbereich des Feldeffekttransistors erzeugt werden, siehe dazu exemplarisch die Figur 4, wodurch der Kleinsignal-Drain-Source-Widerstand vergrößert und somit die intrinsische Verstärkung des Feldeffekttransistors verbessert wird. Durch die Erfindung wird ein Regelsystem beziehungsweise ein Regelkreis realisiert, in welchem mindestens die Gate-Source-Spannung als Eingangsgrößen fungieren, um die als Stellgröße fungierende Backgate-Spannung zu regeln und damit den Drain-Strom auf einen Sollstrom einzustellen. Besonders geeignet ist die Erfindung für Feldeffekttransistoren mit einem starken Durchgriff der Backgate-Spannung auf den Drain-Strom, was beispielsweise bei SOI-oder FDSOI-CMOS-Technologien der Fall ist. Aber auch andere Feldeffekttransistoren, in denen der Drain-Strom sensitiv mittels einer Veränderung der Backgate-Spannung geändert werden kann, können bevorzugt im Sinne der Erfindung verwendet werden. Ein Feldeffekttransistor kann beispielsweise ein IGFET wie beispielsweise ein MOSFET oder ein JFET sein, wobei die Erfindung nicht auf einen bestimmten Feldeffekttransistor beschränkt ist. Beispielsweise kommen sowohl selbstleitende als auch selbstsperrende Feldeffekttransistoren in Betracht. Die Feldeffekttransistoranordnung kann ferner in elektrischen Schaltungen an Stelle eines Feldeffekttransistors des Standes der Technik verschaltet beziehungsweise integriert sein.

Die Regeleinheit ist ferner dazu eingerichtet, auch in Abhängigkeit von der Drain-Source-Spannung am Feldeffekttransistor die Backgate-Spannung zu regeln. Dadurch kann beispielsweise sichergestellt werden, in welchem Betriebsbereich sich der Feldeffekttransistor befindet, beispielsweise im Linearbereich oder im Sättigungsbereich. Die Regeleinheit kann somit eine für den jeweiligen Bereich geeignete Regelung der Backgate-Spannung erzeugen.

Der Sollstrom in einem Sättigungsbereich des Feldeffekttransistors ist unabhängig von der Drain-Source-Spannung. Mit anderen Worten ausgedrückt, wird die Backgate-Spannung von der Regeleinheit derart geregelt, dass der Drain-Strom als Funktion der Drain-Source-Spannung konstant ist. Dadurch wird die intrinsische Verstärkung der Feldeffekttransistoranordnung maximiert.

Die Regeleinheit ist dazu eingerichtet, aus einem bekannten elektrischen Verhalten des Feldeffekttransistors die Backgate-Spannung des Feldeffekttransistors zu regeln. Der Vorteil dieser Ausführung ist es, dass der Drain-Strom des Feldeffekttransistors nicht explizit ermittelt werden muss. Außerdem kann die Regeleinheit zusätzliche Kalibrierungsaufgaben übernehmen, um zum Beispiel Prozessschwankungen auszugleichen. Das bekannte elektrische Verhalten des Feldeffekttransistors ist der Regeleinheit in Form von in einem Speicher abgespeicherten Datensätzen bereitgestellt. Daraus kann dann mittels der Daten sowie der Drain-Source-Spannung und Gate-Source-Spannung eine entsprechende Korrekturgröße für die Backgate-Spannung ermittelt werden.

In einer nicht von den Ansprüchen umfassenden Ausführung kann die Regeleinheit dazu eingerichtet sein, in Abhängigkeit von dem durch den Feldeffekttransistor fließenden Drain-Strom die Backgate-Spannung zu regeln. Somit liegen alle elektrischen Informationen, das heißt Drain-Strom, Gate-Source-Spannung und Drain-Source-Spannung, zur Realisierung eines Regelkreises mit einem Referenzelement vor.

Gemäß einer bevorzugten Ausführungsform umfasst die Feldeffekttransistoranordnung einen Referenzfeldeffekttransistor, an welchem eine gleiche Gate-Source-Spannung wie die Gate-Source-Spannung am Feldeffekttransistor angelegt ist, und wobei ferner am Referenzfeldeffekttransistor eine konstante Drain-Source-Spannung und eine konstante Backgate-Spannung angelegt sind. Dadurch besitzt der durch den Referenzfeldeffekttransistor fließende Drain-Strom vorteilhaft keine Abhängigkeit von der Drain-Source-Spannung.

Die Regeleinheit kann dazu eingerichtet sein, die Backgate-Spannung am Feldeffekttransistor derart zu regeln, dass der Drain-Strom durch den Referenzfeldeffekttransistor identisch ist mit dem Drain-Strom durch den Feldeffekttransistor. Der Drain-Strom durch den Referenzfeldeffekttransistor dient somit als Sollgröße für den Drain-Strom durch den Feldeffekttransistor. Somit wird mittels des Referenzfeldeffekttransistors ein unabhängiger Drain-Strom durch den Feldeffekttransistor eingestellt, welcher unabhängig von der Drain-Source-Spannung ist.

Ferner wird eine elektrische Schaltung, insbesondere eine Verstärkerschaltung, umfassend eine oder mehrere Feldeffekttransistoranordnungen nach einem der vorherigen Ansprüche vorgeschlagen. Elektrische Schaltungen, insbesondere Verstärkerschaltungen, können eine verbesserte Performance aufweisen durch die Elimination beziehungsweise Kompensation von parasitären Effekten des Feldeffekttransistors.

Das erfindungsgemäße Verfahren zum Einstellen eines Drain-Stroms eines Feldeffekttransistors umfasst dabei grundsätzlich die Schritte gemäß Anspruch 3.

Die Vorteile des Verfahrens entsprechen den Vorteilen der obig beschriebenen Feldeffekttransistoranordnung.

Das Regeln der Backgate-Spannung erfolgt ferner auch in Abhängigkeit von der Drain-Source-Spannung.

Der Sollstrom ist in einem Sättigungsbereich des Feldeffekttransistors unabhängig von der Drain-Source-Spannung.

Das Regeln der Backgate-Spannung kann mittels der Regeleinheit aus einem bekannten elektrischen Verhalten des Feldeffekttransistors erfolgen.

Ferner kann in einer nicht von den Ansprüchen umfassten Ausführung das Verfahren das Regeln der Backgate-Spannung in Abhängigkeit von dem durch den Feldeffekttransistor fließenden Drain-Strom umfassen.

Bevorzugt kann das Verfahren das Bereitstellen eines Referenzfeldeffekttransistors umfassen, an welchem eine gleiche Gate-Source-Spannung wie die Gate-Source-Spannung am Feldeffekttransistor angelegt ist, und wobei am Referenzfeldeffekttransistor eine konstante Drain-Source-Spannung und eine konstante Backgate-Spannung angelegt sind.

In einer weiteren bevorzugten Ausführung kann das Regeln der Backgate-Spannung durch die Regeleinheit derart erfolgen, dass der Drain-Strom durch den Referenzfeldeffekttransistor identisch ist mit dem Drain-Strom durch den Feldeffekttransistor.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Ausgangskennlinienfeld eines Feldeffekttransistors des Standes der Technik,
Figur 2 eine erfindungsgemäße Feldeffekttransistoranordnung nach einer ersten Ausführungsform,
Figur 3 eine Feldeffekttransistoranordnung welche nicht von den Ansprüchen umfasst ist, und
Figur 4 ein beispielhaftes Ausgangskennlinienfeld einer erfindungsgemäßen Feldeffekttransistoranordnung.

### Ausführungsformen der Erfindung

In der Figur 1 ist ein Ausgangskennlinienfeld eines Feldeffekttransistors des Standes der Technik gezeigt, bei dem ein durch einen Feldeffekttransistor fließender Drain-Strom I_{D} als Funktion der Drain-Source-Spannung V_{DS} für eine Vielzahl von verschiedenen Gate-Source-Spannungen V_{GS} aufgetragen ist. An dem Feldeffekttransistor gemäß des Standes der Technik ist dabei eine einstellbare, aber konstante Backgate-Spannung an dessen Backgate-Anschluss eingestellt, was hier nicht explizit gezeigt ist. Der funktionale Verlauf des Drain-Stroms I_{D} zu jeder zugehörigen Gate-Source-Spannung V_{GS} zeigt als Funktion der Drain-Source-Spannung V_{DS} einen Linearbereich 40 für genügend kleine Drain-Source-Spannungen V_{DS} und einen Sättigungsbereich 50 für genügend große Drain-Source-Spannungen V_{DS}, wobei die Bereiche zur Anschauung durch eine Trennlinie voneinander getrennt sind. Der in der Figur 1 dargestellte Verlauf des Drain-Stroms I_{D} als Funktion der Drain-Source-Spannung V_{DS} zeigt, dass im Sättigungsbereich 50, auch Pinch-off-Bereich genannt, der Drain-Strom weiterhin als Funktion der Drain-Source-Spannung ansteigt, was unerwünscht und auf parasitäre Effekte zurückzuführen ist. Der Effekt führt nachteilig zu einem geringeren Kleinsignal-Drain-Source-Widerstand und somit zu einer geringeren intrinsischen Verstärkung.

In der Figur 2 wird eine Feldeffekttransistoranordnung 1 nach einer ersten Ausführungsform der Erfindung beschrieben. Die Feldeffekttransistoranordnung 1 ist dabei beispielhaft in einer elektrischen Schaltung, in diesem konkreten Fall in einer Verstärkerschaltung 100, integriert.

Die Feldeffekttransistoranordnung 1 umfasst dabei einen Feldeffekttransistor T mit einem mit einer Backgate-Spannung V_{BG} einstellbaren Backgate-Anschluss BG. Ferner liegt an dem Feldeffekttransistor T eine Gate-Source-Spannung V_{GS} und eine Drain-Source-Spannung V_{DS} an und es fließt ferner ein Drain-Strom I_{D} durch den Feldeffekttransistor T. Rein beispielhaft ist in der vorliegenden Ausführung ein Source-Anschluss S des Feldeffekttransistors T geerdet, sodass die an einem Gate-Anschluss G des Feldeffekttransistors T anliegende Spannung der Gate-Source-Spannung V_{GS} entspricht. Die Erfindung ist dabei jedoch nicht auf eine Erdung des Source-Anschlusses S beschränkt.

Ferner umfasst die Feldeffekttransistoranordnung 1 eine Regeleinheit 10, welche mit dem Backgate-Anschluss BG des Feldeffekttransistors T verbunden ist. Die Regeleinheit 10 ist dabei dazu eingerichtet, den durch den Feldeffekttransistor T fließenden Drain-Strom I_{D} mittels einer Regelung der Backgate-Spannung V_{BG} an dem Backgate-Anschluss BG auf einen Sollstrom einzustellen. Die Regelung der Backgate-Spannung V_{BC} erfolgt in Abhängigkeit von mindestens der Gate-Source-Spannung V_{GS}.

Die Feldeffekttransistoranordnung 1 hat den Vorteil, dass mittels der Regelung der Backgate-Spannung V_{BG} unerwünschte parasitäre Effekte ausgeglichen werden können. Beispielsweise kann der Sollstrom derart gewählt sein, dass der Kleinsignal-Drain-Source-Widerstand entsprechend vergrößert und somit die intrinsische Verstärkung des Feldeffekttransistors T verbessert wird.

Durch die Erfindung wird ein rückgekoppeltes Regelsystem beziehungsweise ein Regelkreis beschrieben, in welchem mindestens die Gate-Source-Spannung V_{GS} als Eingangsgröße fungiert, um die Backgate-Spannung V_{BG}, welche als Stellgröße agiert, zu regeln und damit den Drain-Strom auf einen Sollstrom einzustellen.

Die Regeleinheit 10 regelt zusätzlich auch in Abhängigkeit von der Drain-Source-Spannung V_{DS} am Feldeffekttransistor T die Backgate-Spannung V_{SG}.

Mittels der Drain-Source-Spannung V_{DS} bei gegebener Gate-Source-Spannung V_{GS} kann beispielsweise bestimmt werden, in welchem Betriebsbereich sich der Feldeffekttransistor T befindet, also beispielsweise, ob sich der Feldeffekttransistor T im Sättigungsbereich 50 oder im Linearbereich 40 befindet.

Die Regeleinheit 10 kann dabei beispielsweise dazu eingerichtet sein, die an dem Feldeffekttransistor T anliegende Drain-Source-Spannung V_{DS} und die Gate-Source-Spannung V_{GS} direkt zu detektieren beziehungsweise zu erfassen. Alternativ kann diese auch durch eine entsprechende Messeinheit, welche nicht explizit gezeigt ist, erfasst und an die Regeleinheit 10 übergeben werden.

Insbesondere ist der Sollstrom im Sättigungsbereich 50 des Feldeffekttransistors T unabhängig von der Drain-Source-Spannung V_{DS}. Somit wird die Backgate-Spannung V_{BG} in Anhängigkeit der Eingangsgröße derart geregelt, dass der Drain-Strom I_{D} entsprechend mit diesem konstanten Sollstrom übereinstimmt. Dadurch kann die intrinsische Verstärkung maximiert werden.

In dieser konkreten Ausführungsform erfolgt die Regelung der Backgate-Spannung V_{BG} nur in Abhängigkeit von der Gate-Source-Spannung V_{GS} und der Backgate-Spannung V_{SG}, wobei die Erfindung nicht darauf beschränkt ist.

In dieser Ausführungsform ist die Regeleinheit 10 ferner dazu eingerichtet, aus einem bekannten elektrischen Verhalten des Feldeffekttransistors T die Backgate-Spannung V_{BG} des Feldeffekttransistors T zu regeln. Dazu sind Datensätze von dem Feldeffekttransistor T, welche das elektrische Verhalten des Feldeffekttransistors T beschreiben, in einem Speicher 15 abgelegt. Auf diesen Speicher 15 kann dann die Regeleinheit 10 zugreifen. Zum Beispiel kann die Regeleinheit 10 einen internen Speicher 15 umfassen, in welchem entsprechende Daten über das elektrische Verhalten des Feldeffekttransistors T abgespeichert sind. Beispielsweise können die Daten die Ausgangskennlinien in Form einer I_{D}(V_{DS})-Abhängigkeit für verschiedene Werte von Gate-Source-Spannungen V_{GS} ähnlich zu Figur 1 aufweisen.

Die Regeleinheit 10 kann dann durch das Erfassen der Gate-Source-Spannung V_{GS} und der Drain-Source-Spannung V_{DS} durch Vergleich mit dem bekannten Verhalten eine geeignete Korrekturgröße für die Backgate-Spannung V_{BG} bestimmen. Dadurch wird dann entsprechend ein gewünschter Sollstrom, welcher im Sättigungsbereich 50 konstant ist, durch den Feldeffekttransistor 1 mittels der Backgate-Spannung V_{BC} eingestellt. In dieser Ausführungsführungsform muss vorteilhaft nicht explizit der Drain-Strom I_{D} als Eingangsgröße ermittelt werden. Gegenüber der in Figur 3 beschriebenen Ausführung sind jedoch ein erhöhter Entwurfsaufwand und eine komplizierte Regelungstechnik für die Regeleinheit 10 erforderlich.

Ein beispielhaftes Ausgangskennlinienfeld einer solchen Feldeffekttransistoranordnung 1 kann beispielsweise der Figur 4 entnommen werden.

Eine solche Feldeffekttransistoranordnung 1 kann, wie beispielhaft in der vorliegenden Figur 2 gezeigt, in einer elektrischen Schaltung integriert sein. In dem vorliegenden Beispiel ist die elektrische Schaltung als eine Verstärkerschaltung 100 ausgebildet. Diese Verstärkerschaltung 100 ist in Form einer typischen Source-Schaltung aufgebaut, wobei die Erfindung nicht auf eine bestimmte Schaltung beschränkt ist. Die Verstärkerschaltung 100 in dieser Ausführung umfasst eine Betriebsspannung V_{DD}, welche über einen Lastwiderstand R1 mit dem Drain-Anschluss D des Feldeffekttransistors T verbunden ist. Ein Teil der Betriebsspannung V_{DD} fällt somit stets an dem Lastwiderstand R1 ab. Der Lastwiderstand R1 begrenzt hierbei ferner den Drain-Strom I_{D}. Die Eingangsspannung dieser Verstärkerschaltung 100 wird in dieser Ausführung an dem Gate-Anschluss G des Feldeffekttransistors T angelegt. Am Drain-Anschluss D kann dann eine verstärkte Ausgangsspannung Vₒᵤₜ der Verstärkerschaltung 100 abgegriffen werden. Die Feldeffekttransistoranordnung 1 kann somit an Stelle von einem gewöhnlichen Feldeffekttransistor des Standes der Technik verwendet werden, wobei die elektrische Schaltung, hier die Verstärkerschaltung, gegenüber einer Schaltung des Standes der Technik kein beziehungsweise ein gemindertes parasitäres Verhalten aufweist.

In der Figur 3 ist eine Feldeffekttransistoranordnung 1 gezeigt, welche nicht unter die Ansprüche fällt. Im Folgenden werden dabei die Unterschiede zu der in Figur 2 beschriebenen Ausführungsform näher beschrieben. Für die Gemeinsamkeiten wird auf den Beschreibungsinhalt zu Figur 2 verwiesen.

Wie in der Ausführungsform in Figur 2 umfasst die Feldeffekttransistoranordnung 1 eine Regeleinheit 10, welche mit dem Backgate-Anschluss BG des Feldeffekttransistors T verbunden ist. Die Regeleinheit 10 ist dazu eingerichtet, den durch den Feldeffekttransistor T fließenden Drain-Strom I_{D} mittels einer Regelung der Backgate-Spannung V_{BG} an dem Backgate-Anschluss BG auf einen Sollstrom einzustellen. Die Regelung der Backgate-Spannung V_{BG} erfolgt in dieser Ausführungsform in Abhängigkeit von der Gate-Source-Spannung V_{GS} und zusätzlich in Abhängigkeit von dem Drain-Strom I_{D} durch den Feldeffekttransistor T. Optional kann in dieser Ausführungsform die Regelung auch in Abhängigkeit von der Drain-Source-Spannung V_{DS} erfolgen. Der Drain-Strom I_{D} kann beispielsweise von der Regeleinheit 10 erfasst werden oder aber auch von einer anderen Messeinheit gemessen und an die Regeleinheit 10 übergeben werden. Dadurch stehen der Regeleinheit 10 alle elektrischen Informationen, nämlich der Gate-Source-Spannung V_{GS} und der Drain-Source-Spannung V_{DS} und der Drain-Strom I_{D}, zur Realisierung eines Regelkreises mit einem Referenzelement zur Verfügung.

Als Referenzelement wird in dieser bevorzugten Ausführungsform ein Referenzfeldeffekttransistor T1 verwendet. Dabei liegt in dieser Ausführungsform an dem Referenzfeldeffekttransistor T1 eine Gate-Source-Spannung V_{GS1} an, welche mit der Gate-Source-Spannung V_{GS} des Feldeffekttransistors T identisch ist.

Realisiert ist diese Übereinstimmung in der vorliegenden beispielhaften Ausführungsform durch einen Source-Anschluss S1 des Referenzfeldeffekttransistors T1, welcher wie der Source-Anschluss S geerdet ist und ferner durch eine elektrische Verbindung von dem Gate-Anschluss G des Feldeffekttransistors T zu einem Gate-Anschluss G1 des Referenzfeldeffekttransistors T1 auf einem Potential liegt. Durch die Kopplung der Gates G, G1 sind somit deren elektrische Potentiale stets identisch. Da auch die Source-Anschlüssen S, S1 auf gleichem Potential liegen, da beide geerdet sind, liegt an dem Referenzfeldeffekttransistor T1 stets die gleiche Gate-Source-Spannung V_{GS} = V_{GS1} wie am Feldeffekttransistor T an.

Am Referenzfeldeffekttransistor T1 ist in dieser Ausführungsform ferner eine konstante Drain-Source-Spannung V_{DS1} und eine konstante Backgate-Spannung V_{SG1} angelegt. Dadurch fließt durch den Referenzfeldeffekttransistor T1 ein lediglich von der Gate-Source-Spannung V_{GS} abhängiger Drain-Strom I_{D1} zum Source-Anschluss S1 hin. Dieser Drain-Strom I_{D1} ist somit unabhängig von der Drain-Source-Spannung V_{DS}.

Die Regeleinheit 10 kann dann die Backgate-Spannung V_{BG} am Feldeffekttransistor T derart regeln, dass der Drain-Strom I_{D} durch den Referenzfeldeffekttransistor T1 identisch ist mit dem Drain-Strom I_{D1} durch den Feldeffekttransistor T. Dadurch wird ferner der Drain-Strom I_{D} ebenfalls unabhängig von Drain-Source-Spannung V_{DS}. Der Drain-Strom I_{D1} entspricht somit dem Sollstrom des Regelkreises.

Durch diese Realisierung können somit die Ausgangskennlinien in dem Sättigungsbereich 50 des Feldeffekttransistors 1 konstant gehalten werden, siehe dazu auch beispielhaft Figur 4.

Die Feldeffekttransistoranordnung 1 kann analog zu Figur 1 in einer elektrischen Schaltung, wie zum Beispiel einer Verstärkerschaltung 100, integriert sein, siehe dazu die Ausführung in der Beschreibung zu Figur 2.

In der Figur 4 ist ein beispielhaftes Ausgangskennlinienfeld einer erfindungsgemäßen Feldeffekttransistoranordnung 1 gezeigt. Dabei ist ein Drain-Strom I_{D} als Funktion der Drain-Source-Spannung V_{DS} für eine Vielzahl verschiedener Gate-Source-Spannungen V_{GS} aufgetragen.

Der funktionale Verlauf des Drain-Stroms I_{D} zu jeder Gate-Source-Spannung V_{GS} zeigt wie in der Figur 1 des Standes der Technik einen Linearbereich 40 für genügend kleine Drain-Source-Spannungen V_{DS} und einen Sättigungsbereich 50 für genügend große Drain-Source-Spannungen V_{DS}, wobei die jeweiligen Bereiche zur Veranschaulichung durch eine Trennlinie getrennt sind.

Im Gegensatz zu den in Figur 1 dargestellten Ausgangskennlinien weisen die Ausgangskennlinien im Bereich des Sättigungsbereichs 50 einen nahezu konstanten Verlauf als Funktion der Drain-Source-Spannung V_{DS} beziehungsweise einen zumindest deutlich reduzierten Anstieg auf. In anderen Worten ist der Drain-Strom I_{D} unabhängig von der Drain-Source-Spannung V_{DS}. Vorteilhaft ergibt sich dadurch ein entsprechend vergrößerter Kleinsignal-Drain-Source-Widerstand r_{DS} und somit auch eine verbesserte intrinsische Verstärkung Aᵢ.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

## Patentansprüche

1. Eine Feldeffekttransistoranordnung (1), umfassend:
- einen Feldeffekttransistor (T) mit einem mit einer Backgate-Spannung (V_{BG}) einstellbaren Backgate-Anschluss (BG), wobei ferner an dem Feldeffekttransistor (T) eine Gate-Source-Spannung (V_{GS}) und eine Drain-Source-Spannung (V_{DS}) anliegt sowie ein Drain-Strom (I_{D}) durch den Feldeffekttransistor (T) fließt;
- eine mit dem Backgate-Anschluss (BG) verbundene Regeleinheit (10), welche dazu eingerichtet ist, den durch den Feldeffekttransistor (T) fließenden Drain-Strom (I_{D}) mittels einer Regelung der Backgate-Spannung (V_{BG}) an dem Backgate-Anschluss (BG) auf einen Sollstrom einzustellen, **gekennzeichnet durch**,
- einen Speicher (15), in welchem Daten über ein bekanntes elektrisches Verhalten des Feldeffekttransistors (T) abgelegt sind; und
die Regeleinheit (10) dazu eingerichtet ist, die Backgate-Spannung (V_{BG}) in Abhängigkeit von der Gate-Source-Spannung (V_{GS}), der Drain-Source-Spannung (V_{DS}) und aus den im Speicher (15) abgelegten Daten über das bekannte elektrische Verhalten des Feldeffekttransistors (T) als Eingangsgrößen so zu regeln, dass der Drain-Strom in einem Sättigungsbereich (50) des Feldeffekttransistors (T) unabhängig von der Drain-Source-Spannung (V_{DS}) ist.

2. Elektrische Schaltung, insbesondere eine Verstärkerschaltung (100), umfassend eine oder mehrere Feldeffekttransistoranordnungen (1) nach dem Anspruch 1.

3. Verfahren zum Einstellen eines Drain-Stroms eines Feldeffekttransistors (T), umfassend die Schritte:
- Bereitstellen eines Feldeffekttransistors (T) mit einem mit einer Backgate-Spannung (V_{BG}) einstellbaren Backgate-Anschluss (BG), wobei ferner an dem Feldeffekttransistor (T) eine Gate-Source-Spannung (V_{GS}) und eine Drain-Source-Spannung (V_{DS}) anliegt sowie ein Drain-Strom (I_{D}) durch den Feldeffekttransistor (T) fließt;
- Einstellen des durch den Feldeffekttransistor (T) fließenden Drain-Stroms (I_{D}) auf einen Sollstrom mittels einer Regelung der Backgate-Spannung (V_{BG}) am Backgate-Anschluss (BG) durch eine mit dem Backgate-Anschluss (BG) verbundene Regeleinheit (10),
**dadurch gekennzeichnet, dass**
Daten über ein bekanntes elektrisches Verhalten des Feldeffekttransistors (T) in einem Speicher (15) abgelegt werden, und
die Backgate-Spannung (V_{BG}) in Abhängigkeit von der Gate-Source-Spannung (V_{GS}), der Drain-Source- Spannung (V_{DS}) und der in dem Speicher (15) abgelegter Daten über bekanntes elektrisches Verhalten des Feldeffekttransistors (T) als Eingangsgrößen so geregelt wird, dass der Drain-Strom in einem Sättigungsbereich (50) des Feldeffekttransistors (T) unabhängig von der Drain-Source-Spannung (V_{DS}) ist.

## Claims

1. Field-effect transistor arrangement (1), comprising:
- a field-effect transistor (T) having a back gate terminal (BG) that can be adjusted using a back gate voltage (V_{BG}), wherein a gate source voltage (V_{GS}) and a drain source voltage (V_{DS}) are also applied at the field-effect transistor (T) and a drain current (I_{D}) flows through the field-effect transistor (T);
- a control unit (10) that is connected to the back gate terminal (BG) and is configured to adjust the drain current (I_{D}) flowing through the field-effect transistor (T) to a setpoint current by means of controlling the back gate voltage (V_{BG}) at the back gate terminal (BG),
**characterized by**
- a memory (15) in which data about a known electrical behaviour of the field-effect transistor (T) are stored; and
the control unit (10) is configured to control the back gate voltage (V_{BG}) as a function of the gate source voltage (V_{GS}), the drain source voltage (V_{DS}) and from the data stored in the memory (15) about the known electrical behaviour of the field-effect transistor (T) as input variables so that the drain current is independent of the drain source voltage (V_{DS}) in a saturation range (50) of the field-effect transistor (T).

2. Electrical circuit, in particular an amplifier circuit (100), comprising one or more field-effect transistor arrangements (1) according to Claim 1.

3. Method for adjusting a drain current of a field-effect transistor (T), comprising the steps of:
- providing a field-effect transistor (T) having a back gate terminal (BG) that can be adjusted using a back gate voltage (V_{BG}), wherein a gate source voltage (V_{GS}) and a drain source voltage (V_{DS}) are also applied at the field-effect transistor (T) and a drain current (I_{D}) flows through the field-effect transistor (T);
- adjusting the drain current (I_{D}) flowing through the field-effect transistor (T) to a setpoint current by means of controlling the back gate voltage (V_{BG}) at the back gate terminal (BG) by means of a control unit (10) that is connected to the back gate terminal (BG),
**characterized in that**
data about a known electrical behaviour of the field-effect transistor (T) are stored in a memory (15), and the back gate voltage (V_{BG}) is controlled as a function of the gate source voltage (V_{GS}), the drain source voltage (V_{DS}) and the data stored in the memory (15) about the known electrical behaviour of the field-effect transistor (T) as input variables so that the drain current is independent of the drain source voltage (V_{DS}) in a saturation range (50) of the field-effect transistor (T).

## Revendications

1. Arrangement de transistor à effet de champ (1), comprenant :
- un transistor à effet de champ (T) doté d'une borne de grille arrière (BG) réglable à l'aide d'une tension de grille arrière (V_{BG}), une tension grille-source (V_{GS}) et une tension drain-source (V_{DS}) étant en outre appliquées sur le transistor à effet de champ (T) et un courant de drain (I_{D}) circulant à travers le transistor à effet de champ (T) ;
- une unité de régulation (10) reliée à la borne de grille arrière (BG), laquelle est conçue pour régler le courant de drain (I_{D}) qui circule à travers le transistor à effet de champ (T) à un courant de consigne au moyen d'une régulation de la tension de grille arrière (V_{BG}) au niveau de la borne de grille arrière (BG),
**caractérisé par**
- une mémoire (15), dans laquelle sont enregistrées des données relatives à un comportement électrique connu du transistor à effet de champ (T) ; et
l'unité de régulation (10) est conçue pour réguler la tension de grille arrière (V_{BG}) en fonction de la tension grille-source (V_{GS}), de la tension drain-source (V_{DS}) et à partir des données relatives au comportement électrique connu du transistor à effet de champ (T) enregistrées dans la mémoire (15) en tant que grandeurs d'entrée, de telle sorte que le courant de drain dans une zone de saturation (50) du transistor à effet de champ (T) soit indépendant de la tension drain-source (V_{DS}).

2. Circuit électrique, notamment circuit amplificateur (100), comprenant un ou plusieurs arrangements de transistor à effet de champ (1) selon la revendication 1.

3. Procédé de réglage d'un courant de drain d'un transistor à effet de champ (T), comprenant les étapes :
- fourniture d'un transistor à effet de champ (T) doté d'une borne de grille arrière (BG) réglable à l'aide d'une tension de grille arrière (V_{BG}), une tension grille-source (V_{GS}) et une tension drain-source (V_{DS}) étant en outre appliquées sur le transistor à effet de champ (T) et un courant de drain (I_{D}) circulant à travers le transistor à effet de champ (T) ;
- réglage du courant de drain (I_{D}) qui circule à travers le transistor à effet de champ (T) à un courant de consigne au moyen d'une régulation de la tension de grille arrière (V_{BG}) au niveau de la borne de grille arrière (BG) par une unité de régulation (10) reliée à la borne de grille arrière (BG),
**caractérisé en ce que**
des données relatives à un comportement électrique connu du transistor à effet de champ (T) sont enregistrées dans une mémoire (15) et la tension de grille arrière (V_{BG}) est régulée en fonction de la tension grille-source (V_{GS}), de la tension drain-source (V_{DS}) et des données relatives au comportement électrique connu du transistor à effet de champ (T) enregistrées dans la mémoire (15) en tant que grandeurs d'entrée, de telle sorte que le courant de drain dans une zone de saturation (50) du transistor à effet de champ (T) soit indépendant de la tension drain-source (V_{DS}).
